# EUROPEAN PATENT APPLICATION

(11) **EP 4 468 079 A1**
(43) Date of publication of application: **27.11.2024**
(21) Application number: 23174492.1
(22) Date of filing: 22.05.2023
(51) Int. Cl.: G03F 7/00

(54) **A STAMP FOR USE IN IMPRINT LITHOGRAPHY, A METHOD OF MANUFACTURING THEREOF, AND A METHOD FOR IMPRINT LITHOGRAPHY**

(71) Applicant: Nederlandse Organisatie voor toegepast-natuurwetenschappelijk Onderzoek TNO, 2595 DA 's-Gravenhage (NL)
(72) Inventor: VERBEEK, Roy Gerardus Franciscus Antonius, 2595 DA 's-Gravenhage (NL); AKKERMAN, Hylke Broer, 2595 DA 's-Gravenhage (NL); ZALAR, Peter, 2595 DA 's-Gravenhage (NL); DE HAAS, Gerardus Josephus Adrianus, 2595 DA 's-Gravenhage (NL); BEL, Matheus Godefridus Johannes, 2595 DA 's-Gravenhage (NL)
(74) Representative: V.O.

(57) **Abstract**

A stamp and a method of use of the stamp in imprint lithography. The stamp being configured to form a pattern in a photoresist layer, wherein the stamp comprises a transparent layer and a plurality of protrusions thereon for imprinting the pattern, wherein the plurality of protrusions is made of a flexible composite material with light absorbing properties so as to form a light blocking pattern for selectively blocking light passing therethrough. The inventio also relates to a method of manufacturing the stamp.

## Description

### FIELD OF THE INVENTION

The invention relates to a stamp device for use in imprint lithography. Furthermore, the invention relates to a method of performing (nano)imprint lithography. Further, the invention relates to a method and system for manufacturing a stamp for use in imprint lithography. Additionally, the invention relates to an imprint lithography system. Also, the invention relates to a roll-to-roll system with a stamp for performing (nano)imprint lithography. The invention also relates to the use of a stamp in imprint lithography.

### BACKGROUND TO THE INVENTION

Imprint lithography has emerged as a promising technique for high-resolution, cost-effective pattern transfer onto various substrates. This technique involves the use of a stamp with predefined patterns that, when brought into contact with a photoresist layer, transfers the pattern onto the photoresist. A pattern can be transferred onto any curable polymer layer intended for imprinting. Following this, the polymer is subjected to a curing process and the stamp is subsequently removed. High quality patterns are typically achieved through the process of imprinting. Nonetheless, achieving extremely high aspect ratios presents a challenge as the large contact area makes stamp removal unfeasible. Therefore, the stamp may not always produce uniform and high-quality patterns when dealing with high-aspect ratio structure and/or non-planar substrates.

It is generally difficult to obtain thin-film structures that have a large aspect ratio morphology. Yet, such structures can provide additional or improved functionality in devices. For example, such structures can be employed to realize 3D batteries, optical collimators, flexible ultrasound systems, etc.

High-aspect structures can be obtained for example using UV photolithography with special (negative-tone) photoresists. Due to the light scattering the aspect ratio is limited. Light scattering results in imperfect structures, especially at the bottom of the structure: not all photoresist is developed away. As a result, for example connections between imprinted structures may remain, which are undesirable.

Another well-known method to realize high-aspect structures is embossing. A physical stamp is used to deform a coating (optionally at elevated temperatures). While this works for some material combinations, it typically results in structures that are on top of a continuous layer, the so-called residual layer. This is intrinsic to embossing, as no material is actually removed. To remove this residual layer, a reactive ion etching step is commonly applied that may degrade the underlying layers (etch away, or oxidize).

There is a need for an improved stamp, that preferably can provide for a more uniform and/or high-quality patterns, also when dealing with high-aspect ratio structures and/or non-planar substrates. It is desired that the stamp can handle the limitations that arise due to light scattering, resulting in imperfect structures and unwanted connections between imprinted features. Furthermore, there is a desire for a method that can avoid the formation of a residual layer, and thereby avoiding the need of employing detrimental steps like reactive ion etching for removing of said residual layer. Such additional detrimental step(s) can potentially degrade the underlying layers by etching away or oxidizing the material.

### SUMMARY OF THE INVENTION

It is an object of the invention to provide for a method and a system that obviates at least one of the above mentioned drawbacks.

Additionally or alternatively, it is an object of the invention to provide for an improved design of a stamp for use in imprint lithography.

Additionally or alternatively, it is an object of the invention to improve the manufacturing of a stamp for use in imprint lithography.

Additionally or alternatively, it is an object of the invention to provide for an enhanced imprint lithography system.

Thereto, the invention provides for a stamp for use in imprint lithography, the stamp being configured to form a pattern in a photoresist layer, wherein the stamp comprises a transparent layer and a plurality of protrusions thereon for imprinting the pattern, wherein the plurality of protrusions is made of a flexible composite material with light absorbing properties so as to form a light blocking pattern for selectively blocking light passing therethrough.

Advantageously, the invention provides for an improved stamp design that is well suited for high aspect ratio imprint lithography (e.g. 3D imprint lithography). The light-absorbing properties of the protrusions enable selective light blocking, resulting in enhanced pattern transfer, especially when dealing with high-aspect ratio structures and non-planar substrates. Due to the flexibility, damage during to the imprinted structure can be better avoided. The stamp can be used for the fabrication of various systems and structures. For example, the stamp can be employed in the production of advanced microelectronics, optical components with intricate patterns, etc.

The stamp according to the disclosure offers the advantage of delivering uniform and high-quality patterns, effectively addressing challenges associated with high-aspect ratio structures and non-planar substrates. By successfully managing the limitations arising from light scattering, the stamp ensures precise structures and eliminates unwanted connections between imprinted features. Furthermore, the formation of structures on top of a continuous residual layer can be better avoided, thereby eliminating the need for detrimental steps such as reactive ion etching (RIE). This approach not only streamlines the process but also protects the underlying layers from potential degradation caused by etching or oxidation, resulting in improved overall performance and reliability.

Optionally, the protrusions are adapted to enable an increased aspect ratio in the transferred patterns. This can result in enhanced pattern transfer fidelity for high-aspect ratio structures.

The stamp may be configured to transfer the intricate structures present on its surface to another layer, ensuring precise replication of the predefined patterns on the target photoresist layer.

The stamp usable in the imprint lithography process may be manufactured using a master or a mold, which serves as a template for creating the predefined patterns on the stamp's surface. This fabrication approach offers several benefits. Firstly, using a master or mold allows for the precise replication of complex structures, ensuring that the stamp accurately reproduces the desired patterns on the target photoresist layer. Secondly, this manufacturing method enables the production of multiple stamps with identical features, which can be of significant importance for large-scale manufacturing processes or applications requiring uniform patterning across numerous substrates. Thirdly, the use of a master or mold allows for the incorporation of various materials, including the described composite materials, in the stamp's construction, providing flexibility in optimizing the stamp's properties to suit specific application requirements. Finally, the master or mold approach can be adapted to various fabrication techniques, such as casting, injection molding, or photolithography, making it compatible with a wide range of manufacturing environments and technologies.

To create a stamp, the following steps may be performed: (1) a master is prepared, (2) a matrix containing a UV absorbing agent (e.g. silicone containing black nano-powder) is used, (3) this mixture is applied to the master and subsequently extracted, and (4) transparent silicone is added around it before the entire stamp is removed.

Optionally, the plurality of protrusions is made out of a material comprising a polymer matrix embedded with a light absorbing agent.

By incorporating the light absorbing agent into the polymer matrix, the stamp gains several advantages, such as improved resistance to wear and tear, enhanced durability, and reduced degradation over time. This approach eliminates the need for a separate bonding layer required for bonding an external component (e.g. metal plate), which can wear out more quickly due to stamping. Additionally, the integrated light absorbing agent allows for better control of the stamp's smoothness, which is essential for proper stamp removal and adhesion of the photoresist layer to the substrate. The combination of these factors ultimately results in a more sustainable and efficient stamping process.

Advantageously, there is no connection (e.g. glue) of a base material to a light blocking material (e.g. rigid metal plate). By incorporating the light absorbing agent into the polymer matrix, the smoothness can be significantly improved. The specific surface determines the adhesion of the stamp to the stamped layer, and a higher specific surface makes it more difficult to remove the stamp. If the stamp is rough or becomes rough through use, proper removal becomes more challenging.

The use of a material comprising a polymer matrix embedded with a light-absorbing agent for the protrusions offers the advantage of increased flexibility and durability. The protrusion can be flexible instead of rigid. The material composition of the protrusions effectively block light during the exposure process, ensuring accurate pattern transfer.

Optionally, the light absorbing agent is uniformly distributed within the polymer matrix.

The uniform distribution of the light-absorbing agent within the polymer matrix ensures consistent light absorption properties across the length of the protrusions of the stamp. This uniformity translates to improved pattern transfer accuracy and reproducibility.

For instance, this feature would be beneficial in the fabrication of high-precision sensors or MEMS devices, among other things.

Optionally, the light absorbing agent is an ultraviolet (UV) absorbing agent.

Incorporating an ultraviolet (UV) absorbing agent in the material composition of the protrusions provides the advantage of precise control over the exposure process. This specificity in light absorption reduces the risk of unwanted exposure, leading to higher-quality patterns

Optionally, the light absorbing agent includes a powder.

Including a powder, such as fine particles, as a light-absorbing agent in the protrusions contributes to enhanced light-blocking capabilities. This improvement ensures better pattern transfer fidelity and uniformity.

For example, this feature can be advantageous in the fabrication of nanostructured solar cells, where precise patterning is essential for optimal performance. Various other applications may benefit from the advantageous embodiment.

Optionally, the (average) particle size is less than 5 nanometers to facilitate smooth application and create small features in the stamp. When particles are mixed with a matrix material, they may tend to agglomerate, resulting in clumps. To prevent this, a dispersant may be added during the mixing process.

Optionally, the powder includes a carbon powder, preferably black carbon nano-powder.

Using carbon particles in a fine powder form can be important to avoid roughness in the stamp, especially for smaller dimensions. Roughness can hinder the stamp's removal, as it creates more resistance.

The use of black carbon nano-powder as a light-absorbing agent further enhances the light-blocking efficiency of the protrusions. This enhancement enables even more accurate pattern transfer, particularly for high-aspect ratio structures. A higher aspect ratio enhances the collimating effect. The angular distribution depends on the aspect ratio. The flexibility of the silicone used for the UV absorbing protrusions can be selected based on the structure shape and size.

In some examples, the aspect ratio is larger than 5, preferably larger than 8, even more preferably larger than 10.

Black carbon nano-powder exhibits exceptional light-absorbing properties, which contribute to the improved light-blocking efficiency of the protrusions. This enhanced light-blocking capability ensures more accurate and reliable pattern transfer, especially for high-aspect ratio structures.

Furthermore, black carbon nano-powder has a high surface area, which enables a strong interaction with the polymer matrix, resulting in improved mechanical properties of the composite material. This increased durability and toughness of the protrusions ensure consistent pattern transfer, even under repeated use or harsh processing conditions.

Furthermore, the incorporation of black carbon nano-powder allows for a highly tunable absorption spectrum, enabling customization of the stamp for specific applications or wavelengths. This tunability is advantageous for fabricating wavelength-specific components or devices, such as specialized filters or photodetectors.

Furthermore, the use of black carbon nano-powder in the composite material is cost-effective and environmentally friendly, as carbon-based materials are abundant and readily available. This advantage contributes to the overall sustainability and affordability of the stamp, making it an attractive option for various industries and applications.

In some examples, a powder such as carbon black (e.g. nano-powder), is dispersed in silicone, allowing for easy manipulation of concentrations. In some examples, black carbon nano-powder is added to a silicone to build the stamp in two parts: a transparent piece and a more flexible piece containing black carbon powder, which may absorb UV light. Other powders or dyes can also be used as long as they absorb UV light. The base material can be any flexible, elastic substance that does not break when deformed.

Optionally, the light absorbing agent includes a dye.

Incorporating a dye as a light-absorbing agent in the protrusions allows for the tailored absorption of specific wavelengths, enabling customized pattern transfer capabilities. Using a dye, the stamp can be easily customized for particular applications or wavelengths. This adaptability is advantageous for manufacturing devices or components with specific spectral requirements, such as wavelength-selective filters, sensors, or photonic devices. Dyes may offer a broad range of light-absorbing properties, which can be easily tuned by selecting different dye types or modifying their concentrations within the polymer matrix. This tunability allows for precise control over the stamp's light-absorbing characteristics, ensuring accurate and reliable pattern transfer in diverse imprint lithography processes.

Furthermore, dyes can be chosen based on their compatibility with the polymer matrix, resulting in improved mechanical properties of the composite material. This enhanced durability of the protrusions ensures consistent pattern transfer performance, even under demanding processing conditions or repeated use.

In some examples, both powders and dyes are used. This can further enhance the properties of the protrusions.

It will be appreciated that additionally or alternatively other materials instead of powder materials or dyes may be used for forming a composite material with UV-absorbing qualities.

Optionally, the light absorbing agent includes at least one of the following materials with UV absorbing properties: nanoparticles, metal-organic frameworks (MOFs), conductive polymers, organic-inorganic hybrid materials, liquid crystals, inorganic-organic hybrid nanoparticles.

In this way, the range of light-absorbing capabilities may be broadened. This versatility enables the stamp to cater to a wide array of applications.

Optionally, the composite material has a Young's modulus smaller than 20 GPA, more preferably smaller than 10 Gpa, even more preferably smaller than 5 GPa. In some examples, the composite material has a Young's modulus in a range between 0.01 to 10 GPa, preferably 0.05 to 5 GPa.

Optionally, polymer matrix is a silicone material, such as for example polydimethylsiloxane (PDMS).

Utilizing a silicone material like polydimethylsiloxane (PDMS) for the polymer matrix provides the advantage of increased flexibility, durability, and compatibility with various substrates. This property ensures uniform pattern transfer even on uneven or non-planar surfaces.

Optionally, the transparent material is made out of polymer matrix material.

Constructing the transparent layer from the same polymer matrix material as the protrusions ensures compatibility between the materials, reducing the risk of delamination or deformation. This consistency contributes to improved pattern transfer reliability and longevity. For instance, this feature would be beneficial in the production of long-lasting microfluidic devices or lab-on-chip systems.

Using a polymer matrix material for the transparent layer not only offers excellent compatibility with the composite material of the protrusions, the compatibility resulting in a strong bond between the transparent layer and the protrusions, ensuring consistent and precise pattern transfer during the imprint lithography process, but also results in a good transparency across a broad range of wavelengths. This property allows for the versatile use of the stamp in various applications, including those that require different exposure wavelengths, such as ultraviolet (UV) or visible light. The broad transparency range ensures accurate and efficient light transmission through the transparent layer during exposure, contributing to improved patterning outcomes.

Furthermore, polymer matrix materials often possess excellent mechanical properties, such as flexibility and toughness. These properties enable the stamp to conform to non-planar or irregular substrates more effectively than rigid materials, improving pattern transfer quality on non-planar surfaces. This advantage is particularly beneficial for applications that require high-resolution patterning on curved, flexible, or textured substrates, such as flexible electronics, sensors, or displays.

Also, polymer matrix materials are typically lightweight and easy to process, contributing to the overall ease of manufacturing and handling of the stamp. This advantage can result in cost savings and improved throughput in production environments, making the stamp an attractive option for various industries that require high-quality patterning capabilities.

Optionally, the transparent layer is made out of a first material with a first stiffness and wherein the plurality of materials is made out of a second material with a second stiffness, wherein the first stiffness is higher than the second stiffness.

Designing the transparent layer with a higher stiffness than the flexible protrusions allows for better control over the imprinting process, ensuring uniform pressure distribution and improved pattern transfer accuracy. This advantage is particularly useful in applications where precise pattern alignment is critical, such as for example in the fabrication of multilayered microelectronic devices.

Optionally, the photoresist layer is a light-curable polymer.

It will be appreciated that photoresists are photosensitive materials that undergo chemical changes when exposed to light, making them useful in various photolithography and microfabrication processes. They can be classified into two main categories: positive photoresists and negative photoresists. Light-curable polymers, also known as photopolymers or UV-curable polymers, are materials that harden or cure upon exposure to ultraviolet (UV) light or other forms of radiation. These polymers are often used as photoresists in photolithography processes, as they can provide precise patterning and good resolution. In the case of negative photoresists, the exposed areas of the photoresist become cross-linked and insoluble in the developer solution, whereas the unexposed areas remain soluble and can be removed. This characteristic makes them suitable as light-curable polymers. Some common examples of negative photoresists include SU-8, a popular epoxy-based photoresist, and DNQ-novolac resins. Positive photoresists, on the other hand, become more soluble in the developer solution upon exposure to light. Although they do not act as light-curable polymers in the same way as negative photoresists, they still play a significant role in photolithography and microfabrication processes.

According to an aspect, the invention provides for a method of performing (nano)imprint lithography, comprising the steps of: providing a stamp configured to form a pattern in a photoresist layer, said stamp comprising: a transparent layer and a plurality of protrusions extending from said transparent layer, said protrusions being configured to imprint said pattern in said photoresist layer; and said plurality of protrusions being made of a flexible composite material with light absorbing properties so as to form a light blocking pattern for selectively blocking light passing therethrough; contacting said stamp with said photoresist layer such that said plurality of protrusions imprint said pattern onto said photoresist layer; exposing said photoresist layer to light through said transparent layer, wherein said light passes through said transparent layer and is selectively blocked by said light blocking pattern formed by said plurality of protrusions, thereby inducing a selective reaction in the exposed regions of said photoresist layer; and developing said photoresist layer to remove the selectively non-reacted regions, thereby forming the desired pattern on a substrate.

The stamp according to the disclosure effectively addresses the challenge of producing thin-film structures with large anisotropy, enabling enhanced functionality across a variety of applications, including 3D batteries, optical collimators, and flexible ultrasound devices, etc. By offering a reliable and efficient solution, the stamp not only facilitates the creation of high-quality, high-aspect ratio patterns but also minimizes any adverse effects on underlying layers.

The stamp, with dark features embedded into the protrusions, prevents the residual layer under the features from receiving light (e.g. UV light), allowing it to be washed away and eliminating the need for an additional etching step. A wet rinse step is sufficient, whereas a dry etching step in a vacuum system can be expensive, slow, and may affect the features. Advantageously, the method can be employed with reduced wear and tear compared to conventional methods, making it very suited for roll-to-roll processed. Furthermore, light scattering can be effectively avoided. The stamp can capture scattered light, providing a collimating effect and enabling the creation of structures with much higher aspect ratios.

Silicone can entrap air, simplifying the manufacturing process by allowing air to escape when a vacuum is applied. In some examples carbon powder is used as the UV absorbing agent. The carbon powder may be more durable and last longer than a dye for certain applications.

The use of metal materials in a stamp may hinder its removal. The stamp according to the disclosure can have a desired degree of flexibility. For instance UV-absorbing powder, nanoparticles, dyes, etc. can be mixed with a silicone material, creating a flexible compound.

In some examples, the plurality of protrusions is made out of a material comprising a polymer matrix embedded with a light absorbing agent.

The increased durability can be obtained due to the integration of the agent (e.g. embedding carbon powder, particles, dyes and/or any other light blocking/absorbing agent) within the material itself. During the processing, the agent becomes incorporated into the silicone, rather than just being present on the surface. As a result, the agent is situated inside the material, leading to reduced wear and tear.

Optionally, a roll-to-roll imprinting system is utilized, the roll-to-roll imprinting system being provided with: a first roller having said stamp with said transparent layer and said plurality of protrusions mounted thereon; a second roller having said photoresist layer mounted thereon, wherein said photoresist layer is provided on a flexible substrate; a light source for applying UV radiation; and a mechanism for advancing said flexible substrate with said photoresist layer between said first roller and said second roller; and wherein the method includes the steps of: rotating said first roller and said second roller such that said stamp with said transparent layer and said plurality of protrusions contacts said photoresist layer on said flexible substrate, thereby imprinting said pattern onto said photoresist layer during the roll-to-roll process; and maintaining a pressure between said first roller and said second roller during the roll-to-roll process to ensure uniform imprinting of said pattern onto said photoresist layer; and wherein the light source is configured to provide UV radiation during and/or after imprinting.

Utilizing a roll-to-roll imprinting system in the method offers the advantage of continuous, high-throughput production. The system ensures uniform imprinting of the pattern onto the photoresist layer during the roll-to-roll process, making it ideal for large-scale manufacturing of flexible electronics, solar cells, advanced optical components, etc.

Roll-to-roll processing, particularly for high aspect ratio structures, can pose challenges and may potentially damage to the stamp. Ensuring the protrusions of the stamp have a certain degree of flexibility may be important for avoiding damage during the process, especially for high aspect ratio structures. Hence, according to the invention, potential damage can be better prevented.

Optionally, the light source is provided on an interior of the first roller for performing in-situ application of light/radiation (e.g. UV) during imprinting, wherein the first roller is at least partially transparent to light/radiation.

The light source can be positioned within a transparent drum, enabling in-situ cross-linking during the imprint process while pressure is applied. Alternatively, the light exposure step can be carried out adjacent to the drum after the imprinting process is completed, when pressure is no longer being applied. Following light (e.g. UV) cross-linking, non-exposed areas, non-reacted regions, and any residual layers can be removed through washing or development, a step not feasible in traditional imprint methods. Conventionally, residual layers must be removed using a plasma etcher, which is less compatible with roll-to-roll processes.

According to an aspect, the invention provides for a method of manufacturing a stamp for use in imprint lithography, the method including: forming a flexible composite material with light absorbing properties, the flexible composite material being made out a material comprising a polymer matrix embedded with a light absorbing agent; forming a plurality protrusions on a transparent layer, the plurality of protrusions configured for imprinting a pattern, wherein the plurality of protrusions form a light blocking pattern for selectively blocking light passing therethrough.

The manufacturing method for the stamp, which involves forming a flexible composite material with light-absorbing properties and creating protrusions on a transparent layer, provides the advantage of a consistent and reliable stamp production process. This method ensures the stamp's uniform light-blocking pattern and high-quality pattern transfer capabilities, making it suitable for applications in microelectronics, nanotechnology, and optoelectronics.

Optionally, the composition of the material is selected to have a predetermined target stiffness, wherein the predetermined target stiffness is determined based on the dimensions and/or geometry of the protrusions.

The method of selecting the composition of the material based on predetermined target stiffness, considering the dimensions and/or geometry of the protrusions, ensures optimal performance of the stamp. This tailored approach contributes to improved pattern transfer accuracy and reproducibility, which is advantageous for applications that demand high-precision patterning.

According to an aspect, the invention provides for a system comprising the stamp according to the disclosure, wherein the system is configured for performing imprint lithography.

It will be appreciated that any of the aspects, features and options described in view of the device (e.g. stamp) and system apply equally to the methods and the described use. It will also be clear that any one or more of the above aspects, features and options can be combined.

### BRIEF DESCRIPTION OF THE DRAWING

The invention will further be elucidated on the basis of exemplary embodiments which are represented in a drawing. The exemplary embodiments are given by way of non-limitative illustration. It is noted that the figures are only schematic representations of embodiments of the invention that are given by way of non-limiting example.

In the drawing:
Fig. 1a, 1b show a schematic diagram of embodiments of a stamp;
Fig. 2a, 2b show a schematic diagram of embodiments of a stamp;
Fig. 3 shows a schematic diagram of an embodiment of a method;
Fig. 4a, 4b show experimental results;
Fig. 5 shows an exemplary image of a stamp;
Fig. 6a, 6b show exemplary images of an imprint;
Fig. 7 shows a schematic diagram of a method;
Fig. 8 shows a schematic diagram of a graph; and
Fig. 9 shows a schematic diagram of a roll-to-roll system.

### DETAILED DESCRIPTION

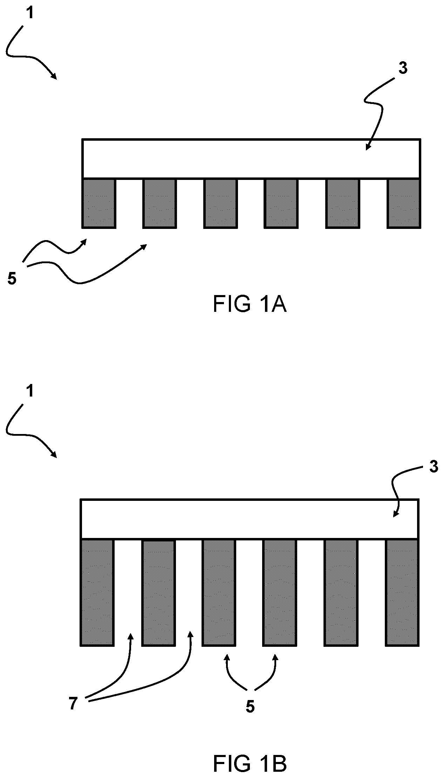

Fig. 1a, 1b show a schematic diagram of embodiments of a stamp 1 for use in imprint lithography. The stamp 1 is configured to form a pattern in a photoresist layer, wherein the stamp comprises a transparent layer 3 and a plurality of protrusions 5 thereon for imprinting the pattern. The plurality of protrusions 5 is made of a flexible composite material with light absorbing properties so as to form a light blocking pattern for selectively blocking light passing therethrough. In this example, the protrusions 5 extend outwardly from a flat surface. However, various other implementations are possible. For instance, the protrusions 5 may extend at least partially in the transparent layer.

In the example shown in fig. 1b, the protrusions 5 are elongated resulting in a high aspect ratio. This can result in enhanced pattern transfer as a more collimated light in the spacing 7 between the protrusions.

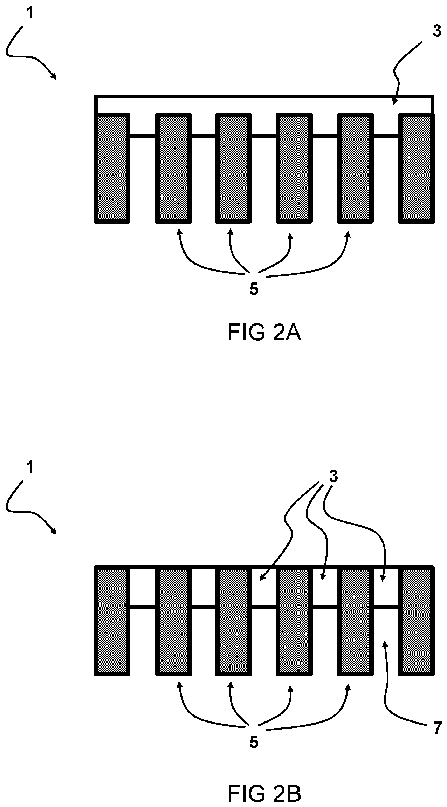

Fig. 2a, 2b show a schematic diagram of embodiments of a stamp 1. In the example shown in fig. 2a, the protrusions 5 extend out of regions with a recess in the transparent layer 3. In the example shown in fig. 2b, the protrusions extend deep into the transparent layer 3. In some examples, the protrusions may be provided in through holes arranged in the transparent layer 3.

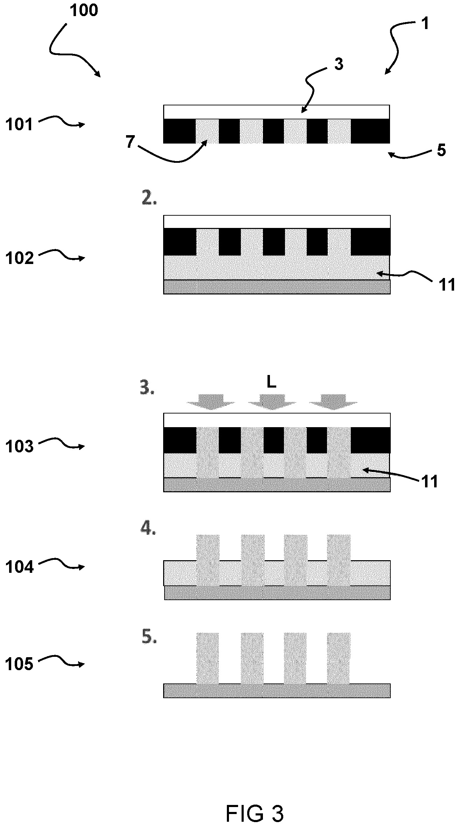

Fig. 3 shows a schematic diagram of an embodiment of an exemplary method 100 of performing imprinting lithography. Advantageously, the stamp can be used for residual layer-free imprinting. The method shown in fig. 3 (cross-sectional side view is shown) may include the steps of:
A first step 101 of providing the stamp according to the disclosure, featuring optically transparent and opaque 3D structures. The stamp 1 may be a PDMS-carbon stamp for example. Between the protrusions 5, open space 7 is provided.
A second step 102 of embossing/imprinting a negative tone photoresist 11, such as SU-8, onto a surface using the stamp 1.
A third step 103 of applying a flood exposure L to the entire surface, allowing the stamp's opaque 3D structures to function as a built-in photomask and effectively block light from reaching the underlying photoresist 11. UV light may be employed for UV cross linking of the negative resist through the partly black stamp 1 at the protrusions 5. Non-exposed resist can be developed away.
A fourth step 104 of removing the stamp to reveal the unexposed portions of the photoresist. The stamp can be released.
A fifth step 105 of using the appropriate developer to eliminate the unexposed photoresist areas, ultimately achieving a patterned surface without any residual layer. Hence, the non-exposed resist can be developed.

This approach demonstrates the versatility and precision of the combined-nanoimprint-and-photolithography (CNP) technique, which merges the benefits of both nanoimprint lithography (NIL) and photolithography.

The imprint lithography technique can combine the benefits of nanoimprint lithography (NIL) and photolithography, resulting in a combined nano-imprint and photolithographic patterning approach. In the combined-nanoimprint-and-photolithography (CNP), a hybrid mask-mold can be used. This mask-mold is made from a UV-transparent material, featuring a light-blocking metal layer placed on top of the mold protrusions. This innovative design allows for more precise and efficient patterning while avoiding the use of sacrificial layers.

In the flood exposure step, a collimated beam may be important for optimal results. A thick layer can be used that effectively absorbs non-collimated light, essentially incorporating a built-in collimator functionality within the stamp design. This innovative feature enhances the performance of the imprinting process by ensuring that only collimated light interacts with the photoresist during the flood exposure, leading to more precise and uniform patterning.

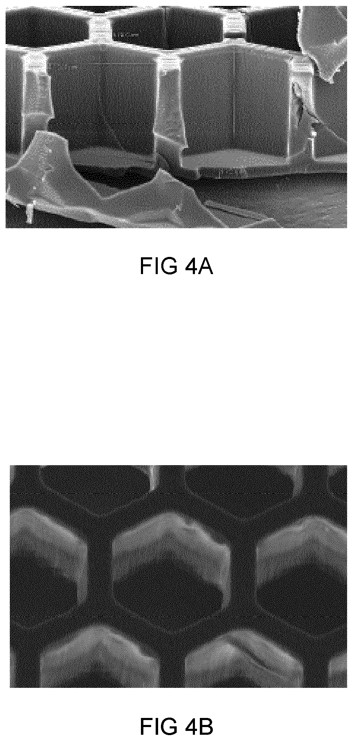

Fig. 4a, 4b show experimental results obtained by means of scanning electron microscopy (SEM), illustrating an imprinted structure obtained by using the stamp according to the disclosure. The stamp 1 was used for creating patterns on surfaces without the need for a sacrificial layer, achieved through a unique stamp design. In the example, the employed stamp had continuous, optically transparent base, topped with opaque ('black') 3D structures. These opaque structures are created by dispersing carbon black particles within a polydimethylsiloxane (PDMS) matrix, although alternative methods for absorbing ultraviolet (UV) light can also be employed.

Parts of the stamp material, namely at least the protrusions, may be infused with UV-absorbing particles or dyes. The UV-absorbing component may be designed as a 3D feature rather than a traditional 2D layer. Advantageously, enhanced stamp durability can be obtained. The stamp's lifetime is significantly longer compared to technique where a metal layer is used, since the metal layer can become damaged over time. Furthermore, improved light management can be obtained. The 3D light-absorbing features effectively eliminate scattered UV light, enabling the creation of structures with higher aspect ratios. The imprinted part of the stamp also functions as a collimator, further contributing to the precision of the process. Also, material customization is enabled. The imprinted portion of the stamp can be made from a different material than the carrier part, allowing for adjustments in elasticity based on specific requirements. These enhancements make the new stamp design more versatile and efficient, with improved performance and longevity.

Fig. 4a shows a SEM image of a conventional imprint with residual layer. It can be observed that the structure shows signs of damage. Fig. 4b shows a SEM image of an imprint obtained by performing the method according to the disclosure, without residual layer.

The reactive ion etching (RIE) step is particularly crucial to avoid when the underlying layers are sensitive to oxidation, as it can cause damage or compromise the material's properties.

According to the disclosure, the light-absorbing features (cf. protrusions 5) can be fabricated without contaminating the surrounding areas with the absorbing material, ensuring clean and precise imprinting. Furthermore, A stable dispersion or solution of nanoparticles or dye in the stamp's matrix material (e.g., carbon nanopowder in a silicone matrix) may be achieved, resulting in homogenous dark areas that effectively absorb light. As a result, an improved performance and precision can be obtained, making the stamp advantageous for various applications in imprinting and lithography.

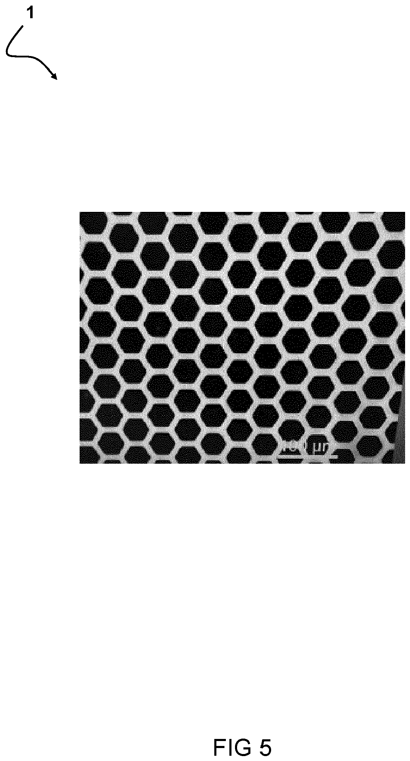

Fig. 5a shows an exemplary image of a stamp obtained by means of SEM. Fig. 5a shows a bilayer stamp 1 with black hexagon features of 40 um width, 40 um height.

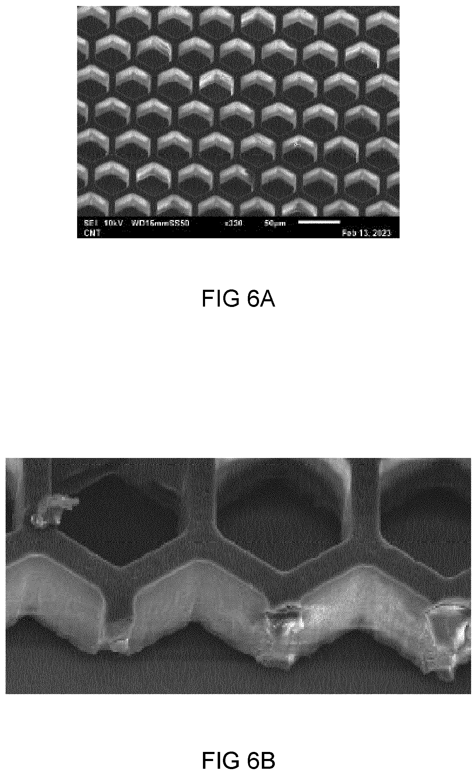

Fig. 6a, 6b show exemplary image of an imprint obtained using the exemplary stamp shown in fig. 5a. The images are also obtained by means of SEM. The experiments demonstrate the effectiveness of the black stamp design when imprinting in a photoresist (SU-8 in this experiment). Following an additional flood exposure and subsequent development step, the residual layer is entirely eliminated. These results showcase the superior performance of the stamp design in achieving clean and precise imprints without any residual layers. Fig. 6b shows a zoomed in SEM image.

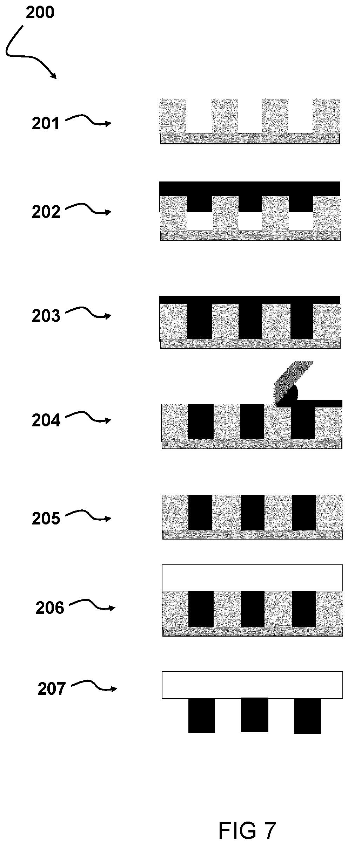

Fig. 7 shows a schematic diagram of a method 200 of manufacturing a stamp 1 according to the disclosure. In a first step 201, a master with e.g. lithographically patterned exemplary SU-8 is provided. The master can be covered with primer. In a second step 202, a thin 'black' silicone layer may be bladecoated through which air can escape. In a third step 203, vacuum is used to release the air from the feature-pockets. In a fourth step 204, a scraping step is performed for striking off the residue. In a fifth step 205, the silicone is cross linked. In a sixth step 206, a full area transparent layer is provided (e.g. PDMS). In a seventh step 207, the stamp is released.

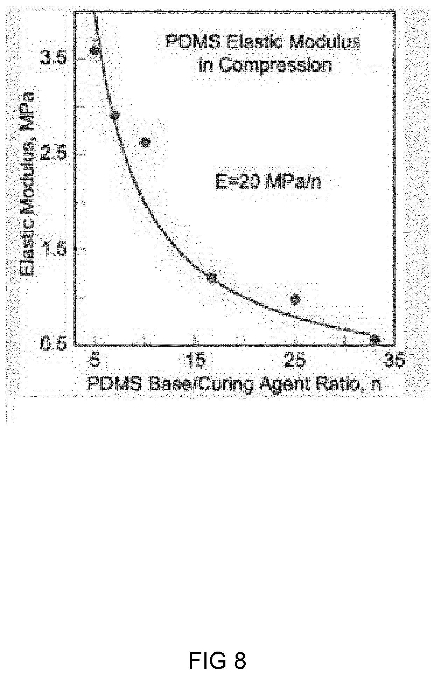

Fig. 8 shows a schematic diagram of a graph presenting the elastic modulus (E-modulus) of exemplary polydimethylsiloxane (PDMS), a type of silicone. The standard mixing ratio for PDMS is 1: 10, which results in an E-modulus of 2.5 MPa. Using different mixing ratios can yield lower E-modulus values and thus allow to control the flexibility. This can thus be used for adjustments in the material's properties depending on the specific requirements of an application in which the stamp is going to be employed. In some examples, the composition of the material is selected to have a predetermined target stiffness, wherein the predetermined target stiffness is determined based on the dimensions and/or geometry of the protrusions.

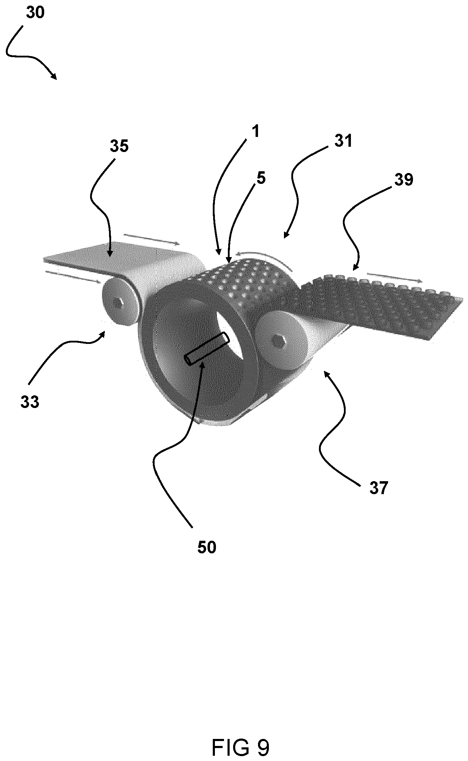

Fig. 9 shows a schematic diagram of a roll-to-roll imprint lithography system 30. The roll-to-roll imprint lithography system 30, comprises: a first roller 31 having a stamp 1 mounted thereon, said stamp 1 including: a transparent layer and a plurality of protrusions extending from said transparent layer, said protrusions being configured to imprint a pattern in a photoresist layer and being made of a flexible composite material with light absorbing properties so as to form a light blocking pattern for selectively blocking light passing therethrough; a second roller 33 having a flexible substrate with a photoresist layer 35 mounted thereon; a third roller 37 configured to receive and support the flexible substrate with the patterned photoresist layer 39 after the imprinting process; a light source configured to emit radiation (e.g. UV light); a mechanism for advancing said flexible substrate 35 with said photoresist layer between said first roller 31, said second roller 35, and said third roller 39; and a pressure control system for maintaining a pressure between said first roller 31 and said second roller 33 during the roll-to-roll process to ensure uniform imprinting of said pattern onto said photoresist layer.

During operation, said first roller 31 and said second roller 33 can rotate such that said stamp 1 with said transparent layer and said plurality of protrusions 5 contacts said photoresist layer on said flexible substrate, imprinting said pattern onto said photoresist layer during the roll-to-roll process. The light source can be configured to provide radiation during and/or after the imprinting process, causing the exposed regions of the photoresist layer to selectively react by passing through said transparent layer and being selectively blocked by said light blocking pattern formed by said plurality of protrusions. A subsequent development process may be employed for removing the selectively non-reacted regions of the photoresist layer, thereby forming the desired photoresist pattern on the flexible substrate, which is then transferred for further processing and/or collection.

In this example, advantageously, the light source 50 is provided on an interior of the first roller 31 for performing in-situ application of radiation (e.g. UV light) during imprinting, wherein the first roller 31 is at least partially transparent to said radiation. The first roller 31 may thus form a transparent drum with a light source arranged therein. The light source 50 may for example be a UV lamp. The outer surface of the first roller 31 may include the patterned structure of the stamp 1.

The photoresist layer may be an uncured polymer. In some examples, a copper foil is employed for carrying the resin layer. In some examples, a resin layer may be applied to a substrate, such as copper foil. The adhesion of the resin layer on the copper foil must be stronger than the adhesion of the stamp to the resin layer; otherwise, the resin layer will be peeled off the copper foil instead of the stamp from the resin layer. Easier stamp removal allows for greater substrate choice. Silicone adheres well to silicone, while metallic foil exhibits poorer adhesion.

Advantageously, the stamp according to the disclosure can be effectively employed in a roll-to-roll process, enabling scalability for various industrial manufacturing processes.

It will be appreciated that next to carbon powder, such as black carbon nano-powder, graphene oxide powder, etc, various other powders may be used for UV light absorption. Examples are titanium dioxide (TiO2), zinc oxide (ZnO), cerium oxide (CeO2), iron oxide (Fe2O3), barium sulfate (BaSO4), tantalum pentoxide (Ta2O5), niobium pentoxide (Nb2O5), manganese dioxide (MnO2), copper oxide (CuO), silica nanoparticles (SiO2), zirconium dioxide (ZrO2), yttrium vanadate (YVO4) doped with europium (Eu). Various other powders may be used.

It will be appreciated that various dyes with UV absorption properties may be used. Examples are perylene-based dyes, anthraquinone dyes, metalloporphyrins dyes, phthalocyanine dyes, cyanine dyes, rhodamine dyes, azo dyes, indoline dyes, squaraine dyes, merocyanine dyes, xanthene dyes, diketopyrrolopyrrole (DPP) dyes, thiazine dyes, naphthol dyes, acridine dyes, hemicyanine dyes, triphenylmethane dyes. Various other dyes may be used.

The above exemplary lists are not exhaustive lists, and there may be numerous other powder materials or dyes with UV absorption properties. The effectiveness of these materials can depend on factors such as particle size, concentration, and the specific application in which they are used.

It will be appreciated that silicone materials can be considered flexible polymer matrices. Silicones are a class of synthetic polymers made from silicon, oxygen, carbon, and hydrogen atoms. They have a range of properties, including flexibility, depending on their chemical structure and formulation. One common type of silicone material that is often used as a flexible polymer matrix is polydimethylsiloxane (PDMS).

There are several flexible polymer matrices that can be used to create composite materials with UV-absorbing properties. Some examples include: polyurethane (PU), polydimethylsiloxane (PDMS), thermoplastic polyurethane (TPU), polyvinyl chloride (PVC), ethylene-vinyl acetate (EVA), polyethylene (PE), styrene-butadiene rubber (SBR), polypropylene (PP), polystyrene-ethylenebutylene-styrene (SEBS), elastomeric polyesters, etc. These flexible polymer matrices can be combined with UV-absorbing materials to create composites that exhibit UV-blocking properties while maintaining their flexibility. Various other polymer matrices may be used.

PDMS is a silicone-based elastomer known for its flexibility, transparency, and resistance to environmental factors like temperature and UV radiation. It can be easily combined with UV-absorbing materials to create a composite material that maintains its flexibility while providing UV-blocking properties.

It will be appreciated that some non-polymeric elastomeric materials, like natural rubber or latex, can be considered flexible materials that are not derived from polymer matrices. Such flexible materials may not be polymer matrices, but they can still be combined with other materials or treated to provide UV-blocking properties.

It will be appreciated that a flexible material may indicate materials that can deform or bend under an applied force or pressure without breaking. This property enables materials to absorb and distribute stress, ultimately returning to their original shape once the force is removed. In contrast, rigid materials represent materials that either strongly resist deformation or fracture when subjected to an applied force.

It will be appreciated that polymer matrix materials are flexible due to their unique molecular structure. These materials consist of long chains of polymer molecules that are intertwined and held together by weaker intermolecular forces, such as van der Waals forces and hydrogen bonds. This structure allows the polymer chains to slide past each other when subjected to an external force, enabling the material to deform and absorb energy without breaking. Upon removal of the force, the polymer chains return to their original positions, contributing to the material's overall flexibility.

Various embodiments may be implemented using hardware elements, software elements, or a combination of both. Examples of hardware elements may include processors, microprocessors, circuits, application specific integrated circuits (ASIC), programmable logic devices (PLD), digital signal processors (DSP), field programmable gate array (FPGA), logic gates, registers, semiconductor device, microchips, chip sets, et cetera. Examples of software may include software components, programs, applications, computer programs, application programs, system programs, machine programs, operating system software, mobile apps, middleware, firmware, software modules, routines, subroutines, functions, computer implemented methods, procedures, software interfaces, application program interfaces (API), methods, instruction sets, computing code, computer code, et cetera.

Herein, the invention is described with reference to specific examples of embodiments of the invention. It will, however, be evident that various modifications, variations, alternatives and changes may be made therein, without departing from the essence of the invention. For the purpose of clarity and a concise description features are described herein as part of the same or separate embodiments, however, alternative embodiments having combinations of all or some of the features described in these separate embodiments are also envisaged and understood to fall within the framework of the invention as outlined by the claims. The specifications, figures and examples are, accordingly, to be regarded in an illustrative sense rather than in a restrictive sense. The invention is intended to embrace all alternatives, modifications and variations which fall within the scope of the appended claims. Further, many of the elements that are described are functional entities that may be implemented as discrete or distributed components or in conjunction with other components, in any suitable combination and location.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to 'only one', but instead are used to mean 'at least one', and do not exclude a plurality. The term "and/or" includes any and all combinations of one or more of the associated listed items. The mere fact that certain measures are recited in mutually different claims does not indicate that a combination of these measures cannot be used to an advantage.

## Claims

1. A stamp for use in imprint lithography, the stamp being configured to form a pattern in a photoresist layer, wherein the stamp comprises a transparent layer and a plurality of protrusions thereon for imprinting the pattern, wherein the plurality of protrusions is made of a flexible composite material with light absorbing properties so as to form a light blocking pattern for selectively blocking light passing therethrough.

2. The stamp according to claim 1, wherein the plurality of protrusions is made out of a material comprising a polymer matrix embedded with a light absorbing agent.

3. The stamp according to claim 2, wherein the light absorbing agent is uniformly distributed within the polymer matrix.

4. The stamp according to claim 2 or 3, wherein the light absorbing agent is an ultraviolet (UV) absorbing agent.

5. The stamp according to any one of the preceding claims 2-4, wherein the light absorbing agent includes a powder.

6. The stamp according to claim 5, wherein the powder includes a carbon powder, preferably black carbon nano-powder.

7. The stamp according to any one of the preceding claims 2-6, wherein the light absorbing agent includes a dye.

8. The stamp according to any one of the preceding claims 2-7, wherein the light absorbing agent includes at least one of the following materials with UV absorbing properties: nanoparticles, metal-organic frameworks (MOFs), conductive polymers, organic-inorganic hybrid materials, liquid crystals, inorganic-organic hybrid nanoparticles.

9. The stamp according to any one of the preceding claims, wherein polymer matrix is a silicone material, such as for example polydimethylsiloxane (PDMS).

10. The stamp according to any one of the preceding claims, wherein the transparent material is made out of polymer matrix material.

11. The stamp according to any one of the preceding claims, wherein the transparent layer is made out of a first material with a first stiffness and wherein the plurality materials is made out of a second material with a second stiffness, wherein the first stiffness is higher than the second stiffness.

12. A method of performing imprint lithography, comprising the steps of:
providing a stamp configured to form a pattern in a photoresist layer, said stamp comprising: a transparent layer and a plurality of protrusions extending from said transparent layer, said protrusions being configured to imprint said pattern in said photoresist layer; and said plurality of protrusions being made of a flexible composite material with light absorbing properties so as to form a light blocking pattern for selectively blocking light passing therethrough;
contacting said stamp with said photoresist layer such that said plurality of protrusions imprint said pattern onto said photoresist layer;
exposing said photoresist layer to light through said transparent layer, wherein said light passes through said transparent layer and is selectively blocked by said light blocking pattern formed by said plurality of protrusions, thereby inducing a selective reaction in the exposed regions of said photoresist layer; and
developing said photoresist layer to remove the selectively non-reacted regions, thereby forming the desired pattern on a substrate.

13. The method according to claim 12, wherein a roll-to-roll imprinting system is utilized, the roll-to-roll imprinting system being provided with:
a first roller having said stamp with said transparent layer and said plurality of protrusions mounted thereon;
a second roller having said photoresist layer mounted thereon, wherein said photoresist layer is provided on a flexible substrate;
a light source for applying UV radiation; and
a mechanism for advancing said flexible substrate with said photoresist layer between said first roller and said second roller;
and wherein the method includes the steps of:
rotating said first roller and said second roller such that said stamp with said transparent layer and said plurality of protrusions contacts said photoresist layer on said flexible substrate, thereby imprinting said pattern onto said photoresist layer during the roll-to-roll process; and
maintaining a pressure between said first roller and said second roller during the roll-to-roll process to ensure uniform imprinting of said pattern onto said photoresist layer; and
wherein the light source is configured to provide UV radiation during and/or after imprinting.

14. A method of manufacturing a stamp for use in imprint lithography, the method including:
forming a flexible composite material with light absorbing properties, the flexible composite material being made out a material comprising a polymer matrix embedded with a light absorbing agent;
forming a plurality protrusions on a transparent layer, the plurality of protrusions configured for imprinting a pattern, wherein the plurality of protrusions form a light blocking pattern for selectively blocking light passing therethrough.

15. The method according to claim 14, wherein the composition of the material is selected to have a predetermined target stiffness, wherein the predetermined target stiffness is determined based on the dimensions and/or geometry of the protrusions.
